Europäisches Patentamt

European Patent Office

Office européen des brevets

(11) Numéro de publication : **0 411 971 B1**

# (12) FASCICULE DE BREVET EUROPEEN

(45) Date de publication du fascicule du brevet :
**24.08.94 Bulletin 94/34**

(51) Int. Cl.$^5$ : **G01R 33/06,** G01C 9/10

(21) Numéro de dépôt : **90401467.7**

(22) Date de dépôt : **31.05.90**

---

(54) **Dispositif de mesure des variations temporelles des trois composantes du champ magnétique local et de l'orientation de l'axe du dispositif par rapport à la verticale du lieu.**

---

(30) Priorité : **24.07.89 FR 8909944**
**17.05.90 FR 9006158**

(43) Date de publication de la demande :
**06.02.91 Bulletin 91/06**

(45) Mention de la délivrance du brevet :
**24.08.94 Bulletin 94/34**

(84) Etats contractants désignés :
**CH DE GB IT LI SE**

(56) Documents cités :
**EP-A- 0 290 811**

(56) Documents cités :
**EP-A- 0 290 811**
**EP-A- 0 363 577**
**DE-A- 1 956 001**
**FR-A- 2 176 773**
**US-A- 2 958 819**
**PATENT ABSTRACTS OF JAPAN, vol. 5, no. 126 (P-075), 14 août 1981; & JP-A-56 066 779 (SHIMADZU CORP.) 05-06-1981**

(73) Titulaire : **CLAUSIN, Jacques**
**35 rue du Clos Baron**
**F-78112 Fourqueux (FR)**

(72) Inventeur : **CLAUSIN, Jacques**
**35 rue du Clos Baron**
**F-78112 Fourqueux (FR)**

Jouve, 18, rue Saint-Denis, 75001 PARIS

## Description

La présente invention concerne un dispositif de mesure de la variation du champ magnétique local destiné à servir de capteur dans les applications telles que le contrôle de mobiles magnétiques ou leur destruction par mesure des variations de champ magnétique qu'ils provoquent et commande la mise de feu d'une charge explosive.

Ce dispositif indique en même temps que la variation du champ magnétique local, le sens de pose du capteur sur le sol et son inclinaison, si celà est nécessaire.

En effet les mines anti-véhicules présentent en général deux faces parallèles. La pose rapide de ces mines ne permet pas de choisir la face dirigée vers la cible, c'est-à-dire la face située vers le haut. Il est alors avantageux d'utiliser une charge explosive d'efficacité identique quelque soit la face située en vision directe de la cible. Ces charges explosives particulières doivent être initiées en des points géométriques différents selon le sens de pose sur le sol. Il est donc nécessaire de connaître ce sens. De même la mine peut ne pas être posée parfaitement à plat sur le sol. L'axe de tir fait alors un angle avec la verticale du lieu. Certaines mines n'ayant qu'une faible efficacité lors de tirs inclinés sur des véhicules blindés, la connaissance de cet angle permet de mieux gérer les décisions de mise de feu afin d'optimiser les performances de la munition.

L'invention concerne un dispositif permettant de mesurer le champ magnétique et d'indiquer le sens de pose sur le sol et l'écart angulaire de l'axe de tir de la charge avec la verticale.

Actuellement, la mesure d'une composante du champ local s'effectue par plusieurs moyens. Le plus économique consiste à utiliser une structure plane constituée d'un film de matériau ferromagnétique et magnétorésistant, découpé et assemblé selon la technique du montage en pont, et sur lequel un dépôt de barettes très conductrices fournit un moyen de mesure d'une composante choisie du champ magnétique local.

Cette structure composée d'un film déposé et photo gravé profite des bas prix de revient de la technologie en couche mince. Elle sera appelée dans la suite de cet exposé sonde élémentaire.

Cependant le procédé souffre d'un défaut physique qui rend son utilisation complexe et coûteuse. La mesure effectuée selon l'axe de la sonde élémentaire déterminé par construction dépend de l'état magnétique du film et de l'induction perpendiculaire à cet axe, donc de son ambiance de stockage et des perturbations magnétiques transitoires, telles que celles provoquées par une explosion nucléaire, ce qui rend alors le dispositif impropre à toute utilisation intelligente exploitant le vecteur champ magnétique dans sa totalité comme dans les allumeurs de mines anti-véhicules actuelles.

Divers procédés ont été imaginés pour supprimer cet inconvénient, par exemple par l'adjonction à chaque sonde élémentaire d'une bobine créant une polarisation magnétique transversale constante ou par commutation de l'aimantation magnétique transversale comme l'indiquent les notes techniques connues sur ce sujet.

Ces procédés ont l'inconvénient de nécessiter ou une énergie importante ou une conception coûteuse.

Le dispositif selon l'invention et caractérisé selon la revendication 1 supprime ces défauts. Il comporte une pyramide triangulaire régulière tronquée en matière thermoplastique ou thermodurcissable ou plus généralement amagnétique obtenue par moulage, de hauteur telle que les lignes de plus grandes pentes fassent entre elles un angle de 90°, et à base et à faces tronquées pour diminuer les volumes inutiles et encombrants. Cette pyramide comporte un trou cylindrique d'axe confondu avec son axe principal défini par la hauteur de la pyramide et dans lequel est inséré un fourreau s'ajustant parfaitement dans le trou ci-dessus.

A une distance de la plus grande base de la pyramide déterminée par une relation expliquée plus loin dans cet exposé, est usinée en partie extérieure du fourreau une gorge torique parallèle à cette base et dont la hauteur de la pyramide est l'axe. Dans cette gorge plusieurs tours d'un fil conducteur de l'électricité isolé sont bobinés et forment bobine d'induction.

Trois sondes élémentaires sont collées sur les 3 faces de la pyramide de telle sorte que les 3 axes de sensibilité soient confondus avec les lignes de plus grande pente. Pour faciliter cette pose des alvéoles de taille identiques à celle des sondes sont aménagées dans les 3 faces de la pyramide.

La position de la gorge torique est calculée pour que le vecteur champ magnétique généré au centre des sondes élémentaires soit parallèle à l'axe de sensibilité de chaque sonde.

Par sonde élémentaire, les 4 sorties correspondant à l'alimentation en courant électrique et à la tension de déséquilibre du pont sont soudées à un circuit imprimé soit en montage de surface soit en montage traversant.

Lors de la mise en route du dispositif complet incluant le capteur triple décrit dans l'invention, les 3 ponts magnétorésistifs sont alimentés avec les tensions convenables conseillées par le constructeur. La tension de déséquilibre de chaque pont est mesurée et mémorisée, soient $V_{xo}$, $V_{yo}$, $V_{zo}$, ces tensions.

Dans un deuxième temps, un courant constant est appliqué à la bobine décrite précédemment, créant un champ magnétique connu par calcul au droit de chaque sonde élémentaire, et dont la composante principale $H_p$ est dans l'axe de sensibilité maximale, l'autre composante étant par son orientation sans influence.

Les tensions de déséquilibre correspondantes Vxe, Vye, Vze sont mémorisées. La sensibilité de chaque sonde élémentaire et alors, à cet instant de :

$$Kx = Hp / (Vxe - Vxo)$$
$$Ky = Hp / (Vye - Vyo)$$
$$Kz = Hp / (Vze - Vzo)$$

Ainsi les mesures effectuées ultérieurement sont rigoureuses. Une mesure à l'instant t, bobine non alimentée, des tensions de déséquilibre Vxt, Vyt, Vzt fournissent alors la valeur de la variation exacte du champ au droit de la sonde:

$$Hvx = (Vxt - Vxo) . kx$$
$$Hvy = (Vyt - Vyo) . ky$$
$$Hvz = (Vzt - Vzo) . kz$$

Afin de s'affranchir des dérives dûes à la température et des variations de sensibilité dûes aux impulsions électromagnétiques parasites, de temps en temps la procédure d'étalonnage est recommencée.

Selon l'invention, le dispositif comporte une bobine d'induction de plusieurs tours de fil conducteur de l'électricité, servant à générer un champ magnétique connu et identique sur les 3 sondes simultanément, dont l'alimentation cyclique et temporaire fournit un procédé d'étalonnage fiable de la sensibilité du capteur.

Selon l'invention, les alvéoles situées sur les 3 faces de la pyramide comportent 3 épaulements latéraux comportant chacun une échancrure d'axe parallèle à l'axe principal de la pyramide, et dont l'ouverture est tournée vers la sonde. Ces échancrures, 2 par 2, servent de guide pour la pose de 3 barreaux ferromagnétiques aimantés. Leur position est imposée par ces guides de telle manière que le plan de symétrie du barreau perpendiculaire à son grand axe soit confondu avec le plan de symétrie de la sonde qui contient l'axe de sensibilité. Ainsi l'axe du champ magnétique créé par chaque barreau est perpendiculaire à l'axe de sensibilité de la sonde, et parallèle à une des plus grandes faces de cette dernière. Cette disposition a l'avantage d'apporter une polarisation magnétique constante et de servir de fixation temporaire pour chaque sonde lors de l'opération de collage.

Selon l'invention la pyramide est fixée à la mine de façon à ce que la base de cette pyramide soit parallèle aux faces horizontales de la mine.

L'indication du sens du capteur, la pyramide ayant son sommet vers le haut ou pyramide ayant son sommet bas, et l'indication de l'écart angulaire de l'axe de la pyramide avec la verticale sont obtenus par les dispositifs et les moyens qui suivent : Une sphère en matériau conducteur, métal ou alliage, repose sur une des 2 surfaces en forme de calotte sphérique dont le centre est situé sur l'axe de la pyramide, du même côté que le centre de la sphère, et tel que le rayon de chaque calotte sphérique soit plus important que le rayon de la sphère.

Selon l'invention les centres des 2 surfaces, en forme de calotte sphérique, occupent une position telle que la sphère n'occupe pas la même position relative par rapport aux 3 sondes, lorsque le capteur est orienté pyramide sommet en haut ou pyramide sommet en bas.

Selon l'invention, les calottes sphériques sont fixées par un moyen connu dans un fourteau cylindrique évidé en sa partie centrale qui forme ainsi un puits cylindrique. La calotte supérieure ferme le puits de manière étanche qui, selon l'invention, est rempli d'un fluide inerte, tel que pétrole ou huile silicone.

Selon l'invention lorsque le capteur doit supporter des chocs importants, les calottes sphériques sont choisies parmi les matériaux isolants durs, tel que céramiques. Le fluide inerte annule les effets néfastes de ces chocs, par répartition des contraintes mécaniques dûes à l'accélération, évitant le marquage de la calotte sphérique sur laquelle s'appuie la sphère pendant le choc.

Selon l'invention, la sphère peut être constituée sans inconvénient en métal ou alliage léger tel que l'aluminium ou le magnésium ou tout autre métal conducteur de l'électricité.

Selon l'invention, le diamètre du puits et le rayon des calottes sphériques sont de taille suffisante pour que, lorsque l'axe du capteur fait avec la verticale un angle de 45° - ou plus selon l'application envisagée - la sphère affleure la surface latérale du puits.

Selon l'invention, la détection du sens du capteur et de l'angle entre la verticale du lieu et l'axe de la pyramide, qui donne donc l'indication complète de l'axe de tir de la charge s'effectue par envoi dans la bobine d'étalonnage décrite précédemment, d'un échelon de courant et lecture dans un délai bref, de l'ordre de 20 à 40 microsecondes de la variation du champ magnétique instantané reçu par les 3 capteurs. La valeur du champ mesuré par les 3 capteurs dépend du champ incident émis par la bobine et des courants de Foucault transitoires générés pendant les premiers instants suivant l'alimentation de la bobine.

Cette valeur du champ mesuré dépend donc, dans ces premiers instants, des positions relatives de la sphère et des sondes. Plus une sonde et un capteur sont proches et plus le champ magnétique reçu est faible, pendant les premiers instants, car le champ reçu dû aux courants de Foucault est plus important.

Selon l'invention, les 3 mesures des 3 champs reçus par les 3 sondes, effectuées au même instant que ce soit simultanément ou après 3 alimentations séquentielles de la bobine par un moyen de conversion analogique digitale connu, fournissent les indications désirées, de sens et d'angle entre la verticale du lieu et l'axe du capteur.

Selon l'invention, les résultats des mesures n'étant pas d'exploitation simple sont comparés à un tableau de valeurs préenregistrées et mémorisées.

La recherche du carré de l'erreur minimale
$$e^2 = (H_{M_1} - H_{ijk_1})^2 + (H_{M_2} - H_{ijk_2})^2 + (H_{M_3} - H_{ijk_3})^2$$

avec $H_{M1}$, $H_{M2}$, $H_{M3}$ les champs mesurés,

et $H_{ijk1}$, $H_{ijk2}$ , $H_{ijk3}$ les valeurs préenregistrées du sens k (k prenant 2 valeurs seules), et des angles j et k de la verticale du lieu par rapport à 2 axes X et Y choisis orthogonaux, fournit alors, selon l'invention, le sens et les inclinaisons dans 2 plans orthogonaux de la verticale du lieu.

Afin de limiter les calculs à la précision utile, les valeurs préenregistrées sont ,à titre d'exemple, pour des angles d'inclinaison maximum de 45° effectués tous les 5 degrés, ce qui nécessite donc 18x 18x2 soit 648 calculs et comparaisons successives.

Selon l'invention le volume de ces calculs n'a guère d'importance car ils ne sont effectués qu'une fois lors de la pose de la mine.

Selon l'invention la bobine d'étalonnage, la sphère et les 2 calottes sphériques sont regroupées en un ensemble cylindrique appelé fourreau par la suite qui s'ajuste dans un trou central d'axe confondu avec l'axe de la pyramide.

L'ensemble est compris dans une enveloppe réalisée en matériau conducteur de l'électricité, s'opposant aux variations rapides de champ magnétique et jouant ainsi le rôle de filtre passe bas anti-repliement.

Enfin le traitement des informations délivrant la valeur du champ vrai au droit de la sonde est amélioré en utilisant la relation matricielle ci-dessous (Hix, Hiy, Hiz sont les vecteurs composantes du vecteur champ magnétique vrai)

$$\begin{vmatrix} Hix \\ Hiy \\ Hiz \end{vmatrix} = \begin{vmatrix} a\ b\ c \\ d\ e\ f \\ g\ h\ i \end{vmatrix} \times \begin{vmatrix} Hvx \\ Hvy \\ Hvz \end{vmatrix}$$

Les coefficients a, b, c ...i dépendent de la géométrie et de la perméabilité des barreaux magnétiques et de l'environnement magnétique proche. Ils sont donc calculés à la suite de mesures d'étalonnage.

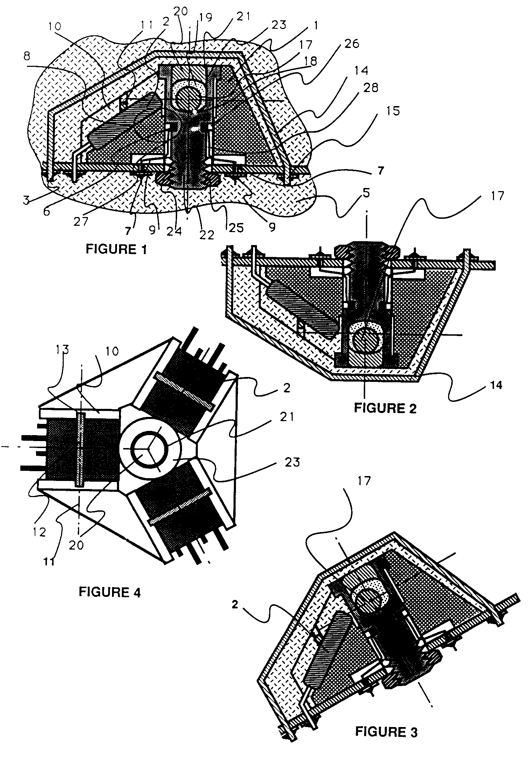

Une description préférentielle non limitative est représentée par les figures 1, 2, 3, 4, 5, 6 , 7 et 8.

La figure 1 montre une coupe de la pyramide (1) sur laquelle est collée une sonde élémentaire (2) soudée au circuit imprimé (3). La bobine (6) est vue en coupe. Ses extrémités (7) sont soudées chacune à une connexion du circuit (9). Le tracé du champ magnétique émis est représenté par la ligne (8). La pyramide (1) comporte 3 zônes creuses obtenues par moulage ayant la forme des sondes élémentaires facilitant la pose précise et le collage des sondes. Les 6 épaulements (10) guident les sondes lors du collage. les échancrures (11) ouvertes dans le sens du démoulage de la pyramide, supportent les 3 barreaux ferromagnétiques aimantés (12) selon l'axe (13). Le capot (14) est fixé au circuit (9) par plusieurs pattes (15). La sphère conductrice (17) est représentée supportée par la calotte sphérique (18). Le puits (19) est rempli de pétrole et est fermé par la calotte sphérique (20).Un joint de colle (21) assure l'étanchéité de cette dernière calotte. La première calotte (18) est soit collée, soit comme représentée figure 1, partie intégrale du fourteau (22) qui comporte en partie supérieure un épaulement (23), et en partie inférieure un filetage (24), permettant par l'écrou (25) l'immobilisation de l'ensemble pyramide (1) sur le support (3). La gorge (26) sert au bobinage de la bobine (6) , les fils de sortie de celles-ci étant protégés par les rainures (27) et (28). Les figures 2 et 3 représentent deux autres coupes du capteur, selon l'axe de la pyramide (1).

La figure 2 représente le capteur dans une position telle que le sommet de la pyramide (1) soit orienté vers le bas.

La figure 3 représente le capteur incliné de 30 degrés par rapport à la verticale, l'angle étant dans un plan passant par l'axe de symétrie d'une sonde (2).

La figure 4 représente une vue de dessus du capteur, capot (14) enlevé.

Les figures 5 et 6 représentent l'évolution temporelle des 3 signaux différentiels reçus par les 3 capteurs, avant et après l'instant où la bobine d'étalonnage est parcourue par le courant constant d'étalonnage.

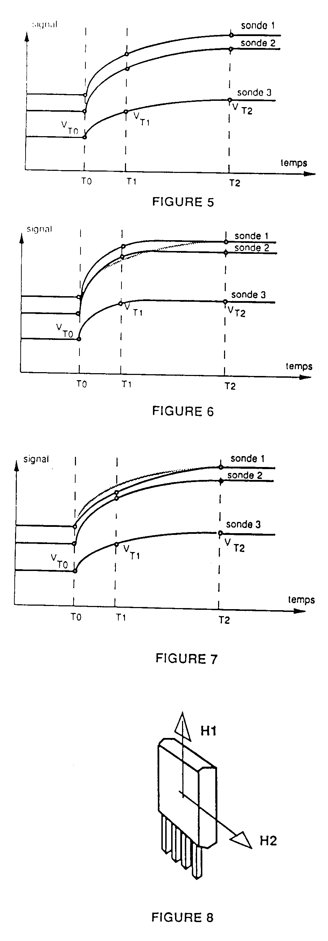

La figure 5 correspond à la position du capteur représenté figure 1, la figure 6 correspond à la position du capteur représenté figure 2. En traits pointillés la courbe d'évolution du champ de la sonde 1, correspondant au sens de la figure 5 a été tracée afin de servir de base de comparaison.

La figure 7 correspond à la position du capteur représenté figure 3. Les rapports des tensions différentielles mesurées au temps To, $T_1$ et $T_2$, soit $(VT_2-VTo)/(VT_1-VTo)$, montrent que ces rapports sont identiques pour les 3 capteurs, figure 5 et 6, mais de valeur différente d'une figure à l'autre. Elles ne diffèrent que par le sens du capteur. Elles diffèrent de l'une à l'autre figure 7 car l'action des courants de Foucault est différente sur chaque capteur.

La figure 8 représente une sonde commerciale montrant son axe de sensibilité H1 et son axe de polarisation influant sur cette première H2.

L'invention trouve son application dans tous les cas où un bas prix de revient et une grande robustesse mécanique est nécessaire, par exemple dans la conception des allumeurs de mines dispersables propulsées par obus ou autres moyens.

## Revendications

1. Dispositif destiné à la mesure des variations des trois composantes orthogonales du champ magnétique local caractérisé en ce qu'il comporte trois sondes magnéto-résistantes (2) fixées sur les faces d'une pyramide triangulaire régulière tronquée (1), les axes de sensibilité des sondes magnéto-résistantes (2) étant orientés selon les trois lignes de plus grandes pentes faisant entre elles des angles de 90°, ladite pyramide étant obtenue par moulage de matière amagnétique, comportant un évidement dans lequel est inséré un fourreau (22) comportant lui- même une gorge torique (26) d'axe confondu avec la hauteur de la pyramide et dans laquelle une bobine de fil (6) génère un champ magnétique connu et identique sur les trois sondes (2), lorsqu'elle est parcourue cycliquement par un courant servant de procédé d'étalonnage de la sensibilité du dispositif, sur les trois sondes sont fixés trois barreaux ferromagnétiques aimantés (12) perpendiculairement à l'axe de sensibilité des sondes et positionnés par l'intermédiaire de deux échancrures latérales (11) venues de moulage sur la pyramide (1), l'ensemble étant enfermé dans un boîtier conducteur (15) formant filtre anti-repliement.

2. Dispositif selon revendication 1 caractérisé en ce que la valeur des composantes du champ est donnée par le produit d'une matrice d'étalonnage 3x3 et des tensions recueillies aux bornes des sondes magnéto-résistantes (2).

3. Dispositif selon revendication 1 caractérisé en ce qu'il comporte une sphère en matériau conducteur (17) placée dans un puits cylindrique (19) d'axe confondu avec l'axe de la pyramide (1) et de diamètre supérieur au diamètre de la sphère (17), le puits étant fermé par deux calottes sphériques (18) et (20) d'axes confondus avec l'axe de la pyramide (1) et de rayon supérieur au rayon de la sphère (17) et séparées par une distance supérieure au diamètre de la sphère (17) et placées de telle manière que la sphère (17) occupe, selon la position du dispositif, deux positions géométriquement différentes relatives aux positions des trois sondes (2), la sphère (17) et les deux calottes sphériques (18) et (20) étant placées dans un fourreau cylindrique (22) d'axe confondu avec l'axe de la pyramide (1), le fourreau (22) comportant un épaulement (23) et un filetage (24) destiné à l'immobilisation de la pyramide (1) sur son support (3), par un écrou (25), le matériau des calottes (18) et (20) et du fourreau (22) pouvant être un matériau dur, céramique lorsque de fortes accélérations sont à craindre, et le puits (19) pouvant être rempli de liquide amortisseur tel que pétrole ou huile de silicone.

4. Dispositif selon revendications 1 et 3 caractérisé en ce que le moyen de recherche de la position et du sens du dispositif est obtenu par une mesure de la variation de champ magnétique dynamique obtenu par l'excitation de la bobine d'étalonnage (6) et la génération de courants de Foucault dans la sphère (17).

5. Dispositif selon revendication 4 caractérisé en ce que la position est déterminée par recherche systématique du minimum d'erreur résultant de la comparaison entre des rapports de valeurs mesurées et une série de rapports de valeurs mémorisées.

**Patentansprüche**

1. Vorrichtung zum Messen der Abweichungen der drei orthogonalen Komponenten des lokalen Magnetfeldes, dadurch gekennzeichnet, dass es aus drei magnetisch-resistenten Sensoren (2) besteht, die auf den Seiten einer regelmässig abgestumpften dreieckigen Pyramide (1) befestigt sind, die Sensibilitätsachsen der magnetisch-resistenten Sensoren (2) sind nach den drei Fallinien orientiert, die voneinander im Winkel von 90° stehen, die genannte Pyramide ist bei einem Abguss vom nichtmagnetischen Kunststoff erreicht, der ein Loch enthält, in dem ein Futteral (22) angeordnet ist, welches Futteral eine torusformige Hohlkehle (26) enthält, derer Achse mit der Höhe der Pyramide verbunden ist, in der eine Spule (6) ein bekanntes Magnetfeld erzeugt, das auf den drei Sensoren (2) identisch ist, wenn sie von einem Strom zyklisch durchgelaufen wird, welches Strom als Eichungsmittel der Sensibilität von der Vorrichtung dient, an den drei Sensoren sind drei ferromagnetische senkrecht der Sensibilitätsachse der Sensoren magnetisierte Sprossen (12) angeordnet, die durch zwei Seitenausschnitte (11) gestellt sind, welche dem Abguss auf der Pyramide folgt, das Ganze in einer leitenden Schachtel (15) eingesperrt, die einen Filter gegen Zurrückzug bildet.

2. Vorrichtung nach Anspruch 1, dadurch gekennzeichnet, dass das Wert der Komponenten von dem Magnetfeld einer 3 x 3 Eichungsmatrize und von den an den Klemmen der magnetisch-resistenten Sensoren (2) aufgesammelten Spannungen gegeben wird.

3. Vorrichtung nach Anspruch 1, dadurch gekennzeichnet, dass sie eine aus einem leitenden Material (17) bestehende Sphäre enthält, welche in einer zylindrischen Bohrung (19) angeordnet ist, derer Achse mit der der Pyramide (1) verbunden ist und derer Durchmesser grösser als der der Pyramide ist (17), die Bohrung wird von zwei Kugelhauben (18) und (20) geschlossen, derer Achsen mit der der Pyramide (1) verbunden sind und derer Durchmesser grösser als der der Sphäre (17) ist und die von einer grössten Distanz als der Durchmesser der Sphäre (17) voneinander getrennt sind, und so eingeordnet, dass die Sphäre (17) nach der Stellung der Vorrichtung zwei geometrisch verschiedene Stellungen, die den Stellungen der drei Sensoren (2) entsprechen, eingeordnet ist, die Sphäre (17) und die zwei Kugelhauben (18) und (20) in einem zylindrischen Futteral (22) eingeordnet, dessen Achse mit der der Pyramide (1) verbunden ist, welches Futteral (22) eine Schultermauer (23) und ein Gewindeschneiden (24) enthält, welches Gewindeschneiden zur Festlegung der Pyramide (1) auf ihrem Stand (3) mit einer Mutter (25) bestimmt ist, das Material der Kugelhauben (18) und (20) und des Futterals (22) kann ein hartes Material sein, wie Keramik wenn hohe Beschleunigungen zu befürchten sind, und die Bohrung (19) kann mit einer Stossdämpferflüssigkeit, wie Petroleum oder Silikonöl gefüllt werden.

4. Vorrichtung nach Ansprüchen 1 und 3, dadurch gekennzeichnet, dass das Forschungsmittel der Stellung und der Richtung der Vorrichtung aus einem Messen der Abweichung von dem dynamischen Magnetfeld folgt, welches Magnetfeld aus der Erregung der Spule (6) und der Erzeugung in der Sphäre (17) von Foucault Strom resultiert.

5. Vorrichtung nach Anspruch 4, dadurch gekennzeichnet, dass die Stellung durch eine systematische Untersuchung der geringsten Unrichtigkeit bestimmt wird, die aus dem Vergleich zwischen den Erträgen von gemessenen Werten und einer Ertragserie von gespeicherten Werten folgen.

**Claims**

1. Device used for the measurement of variations of the three orthogonal components of the local magnetic field characterized by its three magnetoresistent sensors (2) fixed on the sides of a regular triangular troncated pyramid, the sensitivity axes of the magnetoresistent sensors (2) being oriented according to the three lines which have the biggest slopes, having between each other a 90° angle, the said pyramid being obtained by moulding of non-magnetic matters, having a hole in which a cylinder (22) is inserted, the said cylinder being composed of a core gorge (26) which axis will be the pyramid height axis and in which a coil (6) generates a known magnetic field which is identical on the three sensors (2), when the coil is cyclically travelled by a current used as a calibrating process of the device's sensitivity, on the three sensors are fixed three magnetized ferromagnetic rods (12) perpendicular to the sensivity's axis of the sensors and positioned through two lateral indentations (11) resulting from the moulding on the pyramid (1), the whole being enclosed in a conductive box (15) forming an anti-aliasing filter.

2. Device according to claim 1, characterized by the value of the field's components which is given by the product of a 3 X 3 calibrating matrix and of voltages collected on the terminals of the magnetoresistent sensors (2).

3. Device according to claim 1, characterized by a sphere of conducting material (17) located in a cylindrical hole(19) which axis is the same that the pyramid's axis (1) and with a larger diameter than the sphere's diameter (17), the hole being closed by two spherical segments (18) and (20) the pyramid's axis (1) and with a larger diameter than the sphere's diameter (17) and seperated by a bigger distance than the sphere's diameter (17) and located so that according to the device's position the sphere (17) occupies two geometrically different positions relating to the positions of the three sensors (2), the sphere (17) and the two spherical segments (18) and (20) being located in a cylinder (22) one part if it being larger than the rest, and a second part being used as a screw (23) and a screw (24) destined to fix the pyramid (1) on its stand (3), with a nut (25), the material of the spherical segments (18) and (20) of the cylinder (22) can be a hard material, such as ceramic when high accelerations are to be feared, and the hole (19) can be filled with a shock absorbing liquid like kerosene or silicone oil.

4. Device according to claims 1 and 3, characterized by the meaning to find the device's position and the device's direction obtained by a measurement of the variation of the dynamic magnetic field which is obtained by the energizing of the calibrating coil (6) and by the generation of eddy currents in the sphere (17).

5. Device according to claim 4, characterized by the position, which is determined by a systematically researching for minimum error, resulting from the comparaison between the ratios of measured values and a series of ratios of stored values.

FIGURE 1

FIGURE 2

FIGURE 4

FIGURE 3

FIGURE 5

FIGURE 6

FIGURE 7

FIGURE 8